# EUROPEAN PATENT APPLICATION

(11) **EP 1 168 607 A2**
(43) Date of publication of application: **02.01.2002**
(21) Application number: 01202416.2
(22) Date of filing: 22.06.2001
(51) Int. Cl.: H03H 7/01

(54) **An on-chip signal filter with bond wire inductors**

(30) Priority: 22.06.2000 US 599717
(71) Applicant: Texas Instruments Incorporated, Dallas, Texas 75251 (US)
(72) Inventor: Mostafa, Mohamed A., Richardson Texas 75081 (US); Schlang, Jeffrey A., Dallas, Texas 75252 (US); Lazar, Steven, Plano, Texas 75025 (US)
(74) Representative: Holt, Michael

(57) **Abstract**

An on-chip signal filter (200) uses bond wires as well as wire traces connecting IC bond pads to form inductive elements for the signal filter (200). The bond wires and/or traces can be configured in a plurality of ways to formulate different filter types including band pass, low pass, high pass, matching, and notch filters, among others. The bond wires and traces provide sufficiently high Q such that when used in combination with on-chip and/or off-chip capacitors, yield energy efficient filter architectures that conserve integrated circuit real estate.

## Description

### Technical Field of the Invention

This invention relates generally to filtering circuits, and more particularly to an on-chip filter having bond wires configured as filtering inductors.

### Description of the Prior Art

Filtering circuits are well known in the art. Many receiver and transmitters, for example, have a need to filter either before or after an up or down mixer. More specifically, an image rejection mixer is used in a receiver to eliminate the need for additional filtering. This approach leaves the mixer vulnerable to out of band jammers that can cause the mixer to saturate due to the structure of the mixer that allows certain out of band signals to pass unrestricted. When a transceiver, receiver, or transmitter incorporates an image rejection mixer as part of its design, it is often implemented as an application specific IC (ASIC) in which real estate (e.g., die area) and power consumption are a primary concern. Thus, when additional filtering is necessary to eliminate or reduce mixer saturation caused by out of band jammers and/or other noise sources, it is generally necessary to add external (off-chip) filtering and matching components.

In view of the foregoing, techniques of providing additional filtering without using external filter and/or matching components, have been implemented for receivers, transmitters and transceivers that have been fashioned as all or portions of an IC (ASIC). Such techniques use on-chip inductors and have been implemented for many circuit architectures, such as filters and matching networks. These on-chip inductors have been typically defined as a spiral inductor and are well known to those skilled in the filtering art. Spiral inductors, as is known, have typically been used in biasing and stabilizing circuits associated with low noise amplifiers (LNAs) and mixers. The application of spiral inductors has been particularly problematic, however, when they have been applied to filtering applications since they are relatively low Q as compared to discrete inductors. The low Q of spiral inductors yields such inductors too lossy and therefore undesirable for use in on-chip matching networks and band pass filters.

What is needed, in view of the foregoing, is a technique of implementing an integrated filter such as a band pass filter within an ASIC that has a significantly higher Q than that achievable when implementing an integrated filter or matching network using spiral inductor techniques.

### Summary of the Invention

The present invention is directed to an on-chip filter having bond wire inductors. The integrated filter uses IC (ASIC) bond wires as inductors to implement the on-chip filtering (e.g. band pass filter) portion(s) of an integrated transceiver, receiver, or transmitter (e.g., ASIC). When used in combination with internal and/or external IC capacitors, the power consumption of the mixer is reduced since the need for an image rejection mixer is eliminated.

A preferred embodiment of the present on-chip filter comprises at least one IC bond wire and at least one external capacitor configured as an LC band pass filter.

A more preferred embodiment of the present on-chip filter comprises at least one IC bond wire and at least one internal capacitor configured as an LC band pass filter.

Thus, in one aspect of the invention, an integrated band pass filter uses IC bond wires as filter inductors to eliminate the necessity for external filtering and matching components.

In yet another aspect of the invention, an integrated band pass filter uses IC bond wires as filter inductors to reduce the power consumption of an ASIC mixer by eliminating the need for an image rejection mixer.

In still another aspect of the invention, an integrated band pass filter uses IC bond wires as filter inductors to protect an ASIC mixer from off-channel jammers by reducing the jammer signal levels before the signals are received by the mixer.

In still another aspect of the invention, an integrated band pass filter uses IC bond wires as filter inductors associated with MOS, BiCMOS, GaAs, SiGe, and HBT processes, among others, to accommodate higher operating frequencies than that achievable using spiral inductor technology.

In yet another aspect of the invention, IC bond wires are used as matching and/or filtering structures to enhance and augment a variety of applications that have generally been limited by use of spiral inductor technology and the like.

In still another aspect of the invention, traces embedded in the IC or its carrier are used as matching and/or filter structures.

### Brief Description of the Drawings

Other aspects and features of the present invention and many of the attendant advantages of the present invention will be readily appreciated as the same become better understood by reference to the following detailed description when considered in connection with the accompanying drawings in which like reference numerals designate like parts throughout the figures thereof and wherein:
Figure 1 is a diagram illustrating a plurality of IC bond wire configurations suitable for use as inductive elements to formulate an LC filter according to certain embodiments of the present invention;
Figure 2 is a circuit diagram illustrating an LC filter architecture that uses two bond wires to formulate each inductive element of the LC filter according to one embodiment of the present invention;
Figures 3A, B, C are graphs that depict simulation results for the LC filter illustrated in Figure 2, showing the LC filter insertion loss for particular image and PCS band attenuation factors;
Figure 4 is a circuit diagram illustrating another LC filter architecture in which the inductive elements are formulated from bond wire and package inductors according to one embodiment of the present invention; and
Figures 5A, B, C are graphs that depict simulation results for the LC filter illustrated in Figure 4, showing the LC filter insertion loss for particular image and PCS band attenuation factors.

While the above-identified drawing figures set forth alternative embodiments, other embodiments of the present invention are also contemplated, as noted in the discussion. In all cases, this disclosure presents illustrative and exemplary embodiments of the present invention by way of representation and not limitation. Numerous other modifications and embodiments can be devised by those skilled in the art which fall within the scope and spirit of the principles of this invention.

### Detailed Description of the Preferred Embodiments

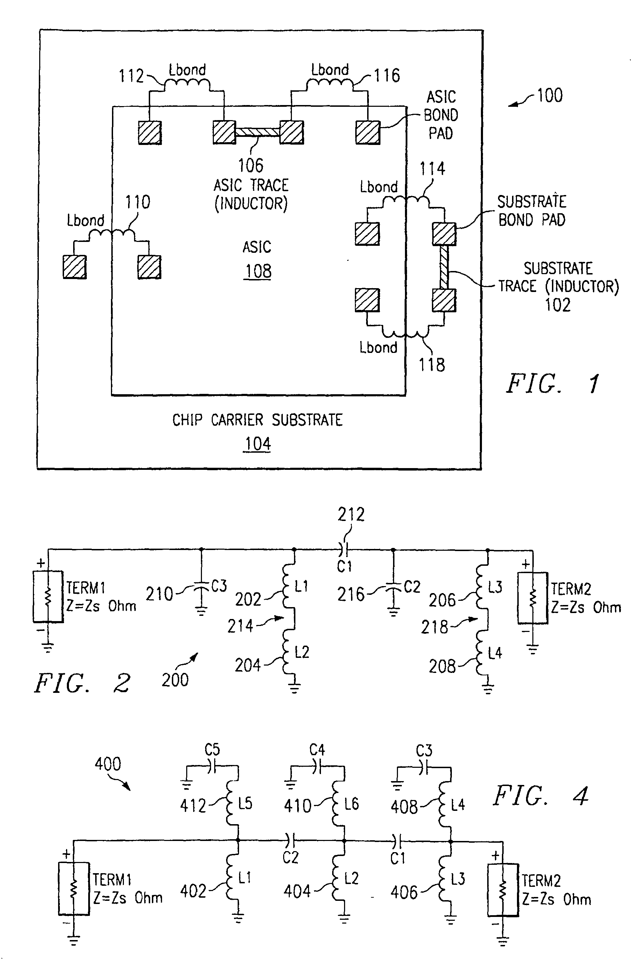

Figure 1 is a diagram illustrating a plurality of IC bond wire configurations 100 suitable for use as inductive elements to formulate an LC filter according to certain embodiments of the present invention. The inductive element structures are not limited to a single bond wire configuration, but can include the inductance of a trace 102 that is either embedded in to the IC carrier substrate 104 or a trace 106 on the IC (ASIC) 108. The inductive element can be formulated from a single bond wire 110 to ground. Some other exemplary on-chip inductive element structures are configured from a bond wire 112, 114 to a pad on the IC 108 or substrate 104 that is connected to another pad on the IC 108 or substrate 104 and that is then connected back to another bond wire 116, 118.

Figure 2 is a circuit diagram illustrating an LC filter 200 architecture that uses two bond wires 202, 204 and 206, 208 to formulate each inductive element, (L1, L2) 214 and (L3, L4) 218, of the LC filter 200 according to one embodiment of the present invention. The LC filter 200, according to one embodiment, uses all on-chip components and includes integrated capacitors 210, 212, 216, manufactured via any suitable RF process such as the RF BiCMOS RF 1 process developed by Texas Instruments Incorporated of Dallas, Texas. Since the LC filter 200 uses two bond wires (e.g., 202 and 204 or 206 and 208), to formulate each inductor 214, 218, a larger inductance value can be achieved accordingly.

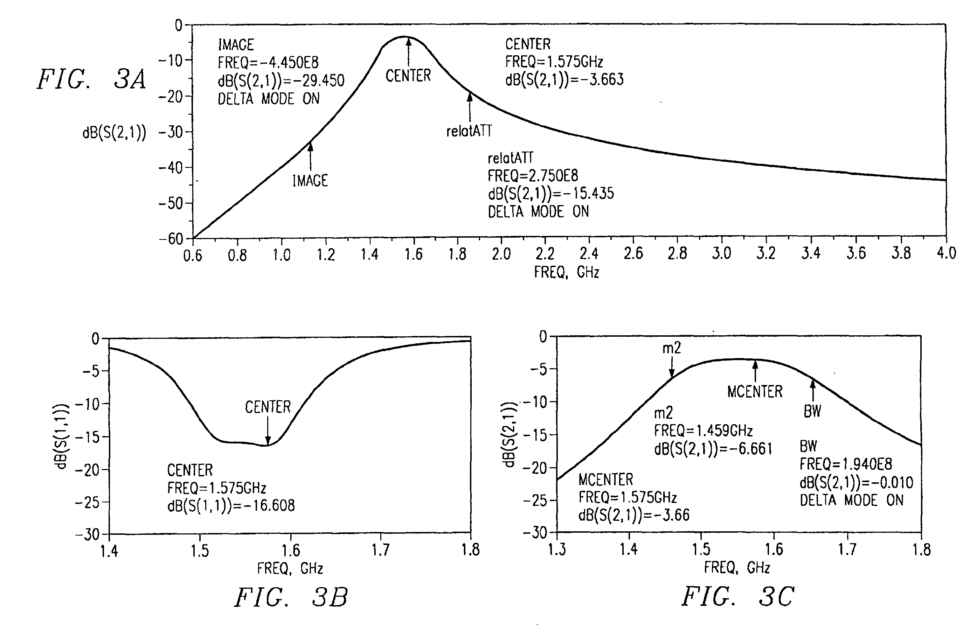

Figures 3A, B, C are graphs that depict simulation results for the LC filter 200 illustrated in Figure 2, showing the LC filter insertion loss for particular image and PCS band attenuation factors using integrated capacitor models from the Texas Instruments Incorporated RF BiCMOS 1 library and bond wire inductor models, also developed by Texas Instruments Incorporated. The LC filter 200 architecture can be seen to yield a 3.7 dB insertion loss while attenuating the image by 29 dB and PCS band by at least 15 dB. The 3 dB bandwidth is seen to be 194 MHz and the output return loss is seen to be about 16 dB for a 500 ohm system.

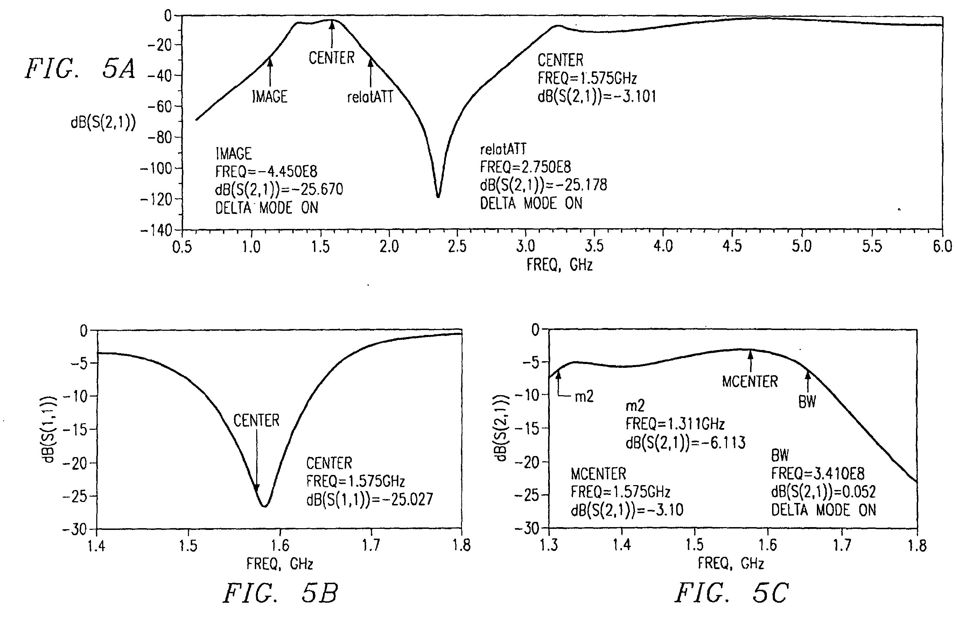

Figure 4 is a circuit diagram illustrating another LC filter 400 architecture in which the inductive elements 402 - 412 are formulated from bond wire and package (trace) inductors according to one embodiment of the present invention. The LC filter 400 is implemented as a fifth order filter to achieve greater stop band attenuation than that which can be achieved using the filter architecture described above with reference to Figure 2. The LC filter 400 was also found to provide a larger 3 dB bandwidth than the LC filter 200 discussed above with reference to Figure 2, making the LC filter 400 more tolerant to process and capacitance variations, using a single bond wire for each inductive element 402 - 412. According to one embodiment, capacitors C1 and C2 are formulated on-chip while capacitors C3 to C5 are off-chip capacitors.

Figures 5A, B, C are graphs that depict simulation results for the LC filter 400 illustrated in Figure 4, showing the LC filter insertion loss for particular image and PCS band attenuation factors using integrated capacitor models from the Texas Instruments Incorporated RF BiCMOS 1 library, as well as external capacitor models and bond wire inductor models, also developed by Texas Instruments Incorporated. The external capacitors C3 - C5 were assumed to have a Q of 100. Using the foregoing constraints, the LC filter 400 architecture can be seen to yield a 3.1 dB insertion loss while attenuating the image by 25 dB and PCS band by at least 25 dB. The 3 dB bandwidth is seen to be 341 MHz and the output return loss is seen to be about 25 dB for a 100 ohm system. Table 1 below summarizes and provides a comparison of the foregoing simulation results for LC filter 200 and LC filter 400.

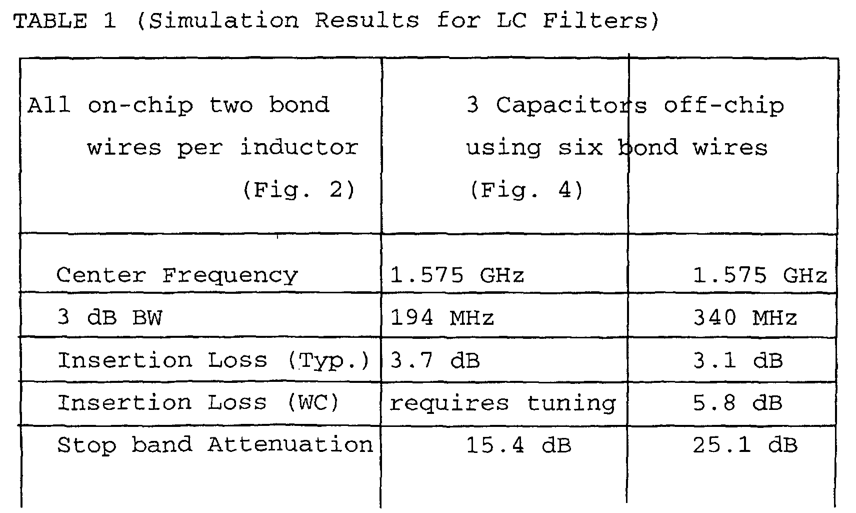

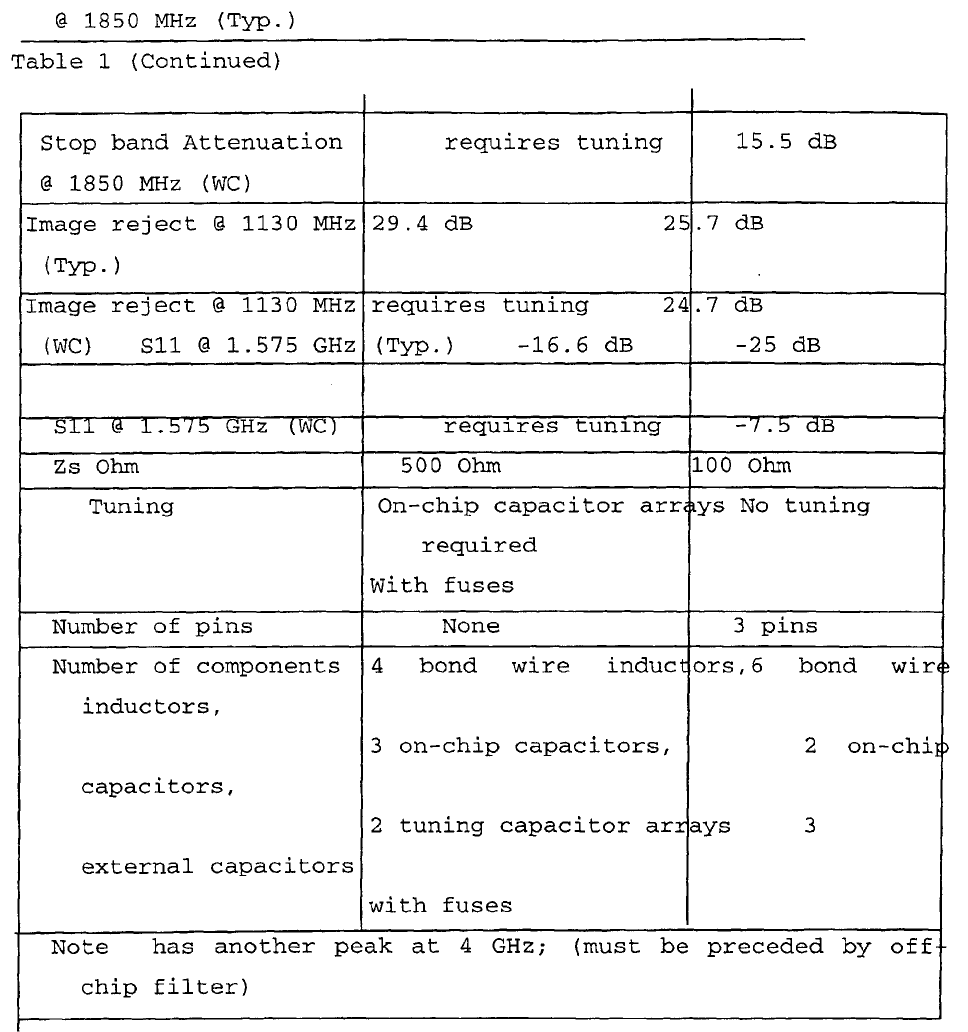

In view of the above, it can be seen the present invention presents a significant advancement in the art of regarding on-chip filtering. This invention has been described in considerable detail in order to provide those skilled in the signal filtering art with the information need to apply the novel principles and to construct and use such specialized components as are required. In view of the foregoing descriptions, it should be apparent that the present invention represents a significant departure from the prior art in construction and operation. However, while particular embodiments of the present invention have been described herein in detail, it is to be understood that various alterations, modifications and substitutions can be made therein without departing in any way from the spirit and scope of the present invention. For example, while the embodiments set forth herein illustrate particular types of LC filters, the present invention could just as well be implemented using other LC filter types, e.g. different topologies and filter orders. Further, while particular embodiments of the present invention have been described herein with reference to structures and methods of filtering, the present invention shall be understood to parallel structures and methods of impedance matching.

## Claims

1. An integrated signal filter comprising:
an integrated circuit comprising a signal filter and having a plurality of bond pads;
an integrated circuit carrier substrate configured to carry the integrated circuit and having a plurality of bond pads; and
a bond wire connected between two bond pads and configured as an inductive element associated with the signal filter.

2. The integrated signal filter according to claim 1 further comprising:
at least one integrated capacitor configured as a capacitive element associated with the signal filter.

3. The integrated signal filter according to claim 2 further comprising:
at least one off-chip capacitor configured as a capacitive element associated with the signal filter.

4. The integrated signal filter according to claim 3 wherein the signal filter is selected from the group consisting of a band pass filter, a low pass filter, a high pass, matching filter, and a notch filter.

5. The integrated signal filter according to any preceding claim, wherein the bond wire is connected at one end to an integrated circuit bond pad and at its opposite end to a carrier substrate bond pad.

6. The integrated signal filter according to any of claims 1 to 4, wherein the bond wire is connected at one end to an integrated circuit bond pad and at its opposite end to a different integrated circuit bond pad.

7. The integrated signal filter according to any of claims 1 to 4, wherein the bond wire is connected at one end to a carrier substrate bond pad and at its opposite end to a different carrier substrate bond pad.

8. An integrated signal filter comprising:
an integrated circuit comprising a signal filter and having at least one bond pad; and
a bond wire connected at one end to at least one bond pad and connected at its opposite end to ground to form an inductive element associated with the signal filter.

9. The integrated signal filter according to claim 8 further comprising:
at least one on-chip capacitor configured as a capacitive element associated with the signal filter.

10. The integrated signal filter according to claim 9 further comprising:
at least one off-chip capacitor configured as a capacitive element associated with the signal filter.

11. The integrated signal filter according to claim 8 further comprising:
an integrated circuit carrier substrate having at least one bond pad.

12. The integrated signal filter according to claim 11 further comprising:
a bond wire connected at one end to at least one integrated circuit bond pad and connected at its opposite end to at least one carrier substrate bond pad to form an inductive element associated with the signal filter.

13. The integrated signal filter according to claim 12 wherein the signal filter is configured as a filter selected from the group consisting of a band pass filter, low pass filter, high pass filter, matching filter, and notch filter.

14. An integrated circuit signal filter comprising:
an integrated circuit comprising a signal filter, a plurality of circuit traces and a plurality of bond pads, wherein at least one circuit trace is configured as an inductive element associated with the signal filter;
at least one bond wire connected at one end to a bond pad and connected at its opposite end to a different bond pad to form an inductive element associated with the signal filter; and
at least one capacitor configured as a capacitive element associated with the signal filter.

15. The integrated circuit signal filter according to claim 14, wherein the signal filter is configured as a signal filter selected from the group consisting of a band pass filter, low pass filter, high pass filter, matching filter, and notch filter.

16. The integrated circuit signal filter according to claim 14, wherein at least one capacitor comprises an on-chip capacitor.

17. The integrated circuit signal filter according to claim 14, wherein at least one capacitor comprises an off-chip capacitor.

18. An integrated circuit signal filter comprising:
an integrated circuit comprising at least one bond pad;
an integrated circuit carrier substrate configured to carry the integrated circuit and having at least one bond pad; and
a conductor trace connected at one end to at least one bond pad and connected at its opposite end to a different bond pad to form an inductive element associated with the signal filter.

19. The integrated circuit signal filter according to claim 18 further comprising:
a bond wire connected at one end to at least one bond pad and connected at its opposite end to a different bond pad to form an inductive element associated with the signal filter.

20. The integrated circuit signal filter according to claim 19 further comprising:
at least one on-chip capacitor configured as a capacitive element associated with the signal filter.

21. The integrated circuit signal filter according to claim 19 further comprising:
at least one off-chip capacitor configured as a capacitive element associated with the signal filter.

22. The integrated circuit signal filter according to claim 18, wherein the conductor trace is embedded within the carrier substrate.

23. The integrated circuit signal filter according to claim 18, wherein the conductor trace is configured as a portion of the integrated circuit.

24. An on-chip signal filter comprising:
at least one bond wire connected at one end to a first bond pad and connected at its opposite end to a second bond pad to form an on-chip inductive element associated with the on-chip signal filter; and
at least one capacitor configured as a capacitive element associated with the on-chip signal filter, wherein the at least one bond wire and the at least one capacitor are configured as a signal filter selected from the group consisting of a band pass filter, low pass filter, high pass filter, matching filter, and notch filter.

25. The on-chip signal filter according to claim 24, wherein the at least one bond wire is a wire trace.

26. The on-chip signal filter according to claim 24 or claim 25, wherein the at least one capacitor comprises an on-chip capacitor.

27. The on-chip signal filter according to any of claims 24 to 26, wherein the at least one capacitor comprises an off-chip capacitor.

28. The on-chip signal filter according to any of claims 24 to 27, further comprising:
a wire trace connected at one end to a bond pad and connected at its opposite end to a different bond pad to form an inductive element associated with the signal filter.

29. An on-chip signal filter comprising:
a signal filter having a plurality of bond pads;
a plurality of bond wires connected to bond pads selected from the plurality of bond pads to form a plurality of inductive elements associated with the signal filter; and
a plurality of capacitors connected to bond pads selected from the plurality of bond pads to form a plurality of capacitive elements associated with the signal filter, wherein the plurality of bond wires and plurality of capacitors are configured as a signal filter selected from the group of filters consisting of a band pass filter, low pass filter, high pass filter, matching filter, and notch filter.

30. The on-chip signal filter according to claim 29, wherein the signal filter comprises an integrated circuit.

31. The on-chip signal filter according to claim 30, wherein the signal filter further comprises a chip carrier substrate.

32. The on-chip signal filter according to any of claims 29 to 31, wherein at least one capacitor comprises an on-chip capacitor.

33. The on-chip signal filter according to any of claims 29 to 32, wherein the at least one capacitor comprises an off-chip capacitor.

34. The on-chip signal filter according to any of claims 29 to 33, wherein at least one bond wire comprises a wire trace.
